# EUROPÄISCHE PATENTANMELDUNG

(11) **EP 0 906 011 A2**
(43) Veröffentlichungstag der Anmeldung: **31.03.1999**
(21) Anmeldenummer: 98116621.8
(22) Anmeldetag: 02.09.1998
(51) Int. Cl.: H05K 13/04, H05K 13/02

(54) **Vorrichtung zum Bestücken von flachen Bauelementeträgern mit elektrischen Bauelementen**

(30) Priorität: 24.09.1997 DE 19742186
(71) Anmelder: SIEMENS AKTIENGESELLSCHAFT, 80333 München (DE)
(72) Erfinder: Mehdianpour, Mohammad, 81829 München (DE)

(57) **Zusammenfassung**

Elektrische Bauelemente (3) werden aus seitlich eines Bestückbereiches (2) angeordneten Zuführmodulen (6) entnommen und auf ein umlaufendes Saugband aufgesetzt, daß die Bauelemente bis über den Bestückbereich transportiert. Ein Bestückkopf (4) entnimmt in einem kontinuierlichen Vorgang die Bauelemente vom Saugband (9) und setzt sie auf einen Bauelementeträger (1) auf.

Dadurch wird die Bestückleistung erheblich gesteigert.

## Beschreibung

Die Erfindung bezieht sich auf eine Vorrichtung zum Bestücken von flachen Bauelementeträgern mit elektrischen Bauelementen, insbesondere SMT-Bauelementen mittels eines revolverartigen drehbaren Bestückkopfes mit mehreren zirkulär angeordneten, z.B. pipettenartigen Greifern für die Bauelemente.

Eine derartigen Vorrichtung ist z.B. durch die US 4,875,285 bekannt geworden. Danach ist der als Leiterplatte ausgebildete Bauelementeträger in einem Bestückbereich der Vorrichtung fixierbar und der Bestückkopf über den Bestückbereich verfahrbar. Die Bauelemente sind in einem, dem Bestückkopf zugänglichen Abholbereich bereitgehalten und werden von den als Saugpipetten ausgebildeten Greifern aufgenommen und zu ihren Bestückpositionen im Bestückbereich verfahren, wo sie auf die Leiterplatte aufgesetzt werden. Der Bestückbereich und der Abholbereich liegen räumlich getrennt in einer Ebene. Im Abholbereich werden die Bauelemente von den als Saugpipetten ausgebildeten Greifern der Reihe nach aufgenommen. Sodann wird der Bestückkopf über die Leiterplatte verfahren, worauf die Bauelemente der Reihe nach auf diese aufgesetzt werden. Darauf fährt der Bestückkopf zum Abholbereich zurück. Die Zykluszeit ergibt sich aus dem Zeitaufwand für diese vier Einzelphasen.

Der Erfindung liegt die Aufgabe zugrunde, die Bestückleistung der Vorrichtung zu erhohen.

Diese Aufgabe wird durch die Erfindung gemäß Anspruch 1 gelöst. Der Bestückkopf benötigt nun für das Aufsetzen und das Abholen zwei getrennte Stationen, bei denen die sternförmig angeordneten Pipetten in die Richtung der Bauelemente bzw. der Leiterplatte verschiebbar sind. Die Bauelemente werden nun jedoch in einer zweiten, zur Bestückebene parallelen Ebene bereitgehalten. Diese Ebene befindet sich oberhalb der Bestückebene in einem Abstand zu dieser, der dem Funktionsdurchmesser des Bestückkopfes entspricht.

Um die Bauelemente von einer Ebene zur anderen zu transportieren wird keine Verfahrweg benötigt. Da der Abholbereich innerhalb des Bestückbereiches liegt, kann der Verfahrbereich des Bestückkopfes erheblich verkleinert werden, was eine erheblich kompaktere und leichtere Ausführung der Antriebe und der Führungsmittel für den Bestückkopf ermöglicht.

Durch die Verkürzung des Abholweges kann die Bestückleistung der Vorrichtung erheblich gesteigert werden. Es besteht die Möglichkeit, daß der Bestückkopf Bauteile kontinuierlich aufnimmt und auf die Leiterplatte aufsetzt, wobei das Abholen und das Absetzen in wechselnder Reihenfolge stattfindet. Es besteht aber auch die Möglichkeit, zumindest einen Teil der Bauteile im Abholbereich so zu plazieren, daß der Abholvorgang und ein Aufsetzvorgang gleichzeitig erfolgt.

Beim Bestücken einer waagerecht liegender Leiterplatte nach Anspruch 2 werden die Bauelemente von oben auf diese aufgesetzt, so daß die abzuholenden Bauelemente auf der Unterseite der Fixiereinrichtung bereitgehalten werden müssen, wobei diese Fixiermittel aufweist, die das Abfallen der Bauelemente verhindern.

Durch die Verfahrbarkeit der Fixiereinrichtung nach Anspruch 3 wird erreicht, daß die Bauelemente in eine jeweils günstige Abholposition bewegt werden können, die in der Nähe einer der Aufsetzpositionen liegt.

Durch die Einrichtung nach den Ansprüchen 4 und 5 kann ein Abholtakt und ein Aufsetztakt zeitgleich und somit zeitsparend erfolgen. Dadurch ist es möglich, die Bauelemente in ununterbrochener Reihenfolge aufzunehmen und nach einer halben Umdrehung des Bestückkopfes auf die Leiterplatte aufzusetzen. Die Verfahrwege werden dann von Position zu Position sehr kurz, wodurch die Bestückleistung erheblich gesteigert werden kann.

Das Fixierband nach den Ansprüchen 6 und 7 ermöglicht es, die Bauteile über der gesamten Bestückfläche bereitzuhalten und von den Zuführmodulen kontinuierlich zuzuführen

Die Übergabeeinrichtung nach Anspruch 8 kann ähnlich dem Bestückkopf ausgebildet sein und die Bauteile von den Zuführmodulen abholen und an der gewünschten Position auf das Fixierband aufsetzen. Da ein solcher Revolverkopf lediglich eine reine Transportfunktion hat, kann er einfacher und leichter ausgebildet werden, als ein Bestückkopf, der neben der Abhol- und der Aufsetzstation noch weitere Stationen, z.B. für die optische Vermessung und für die Korrektur der Drehlage benötigt. Da die Übergabeeinrichtung nur in einer linearen Richtung bewegt werden muß, kann die Verfahrgeschwindigkeit erhöht werden, so daß trotz der erforderlichen Verfahrwege eine hohe Taktrate möglich ist.

Das Saugband nach den Ansprüchen 9 und 10 ermöglicht eine einfache Fixierung von Bauelementen unterschiedlicher Größe und Gestalt an beliebigen Stellen ohne hohen konstruktiven Aufwand.

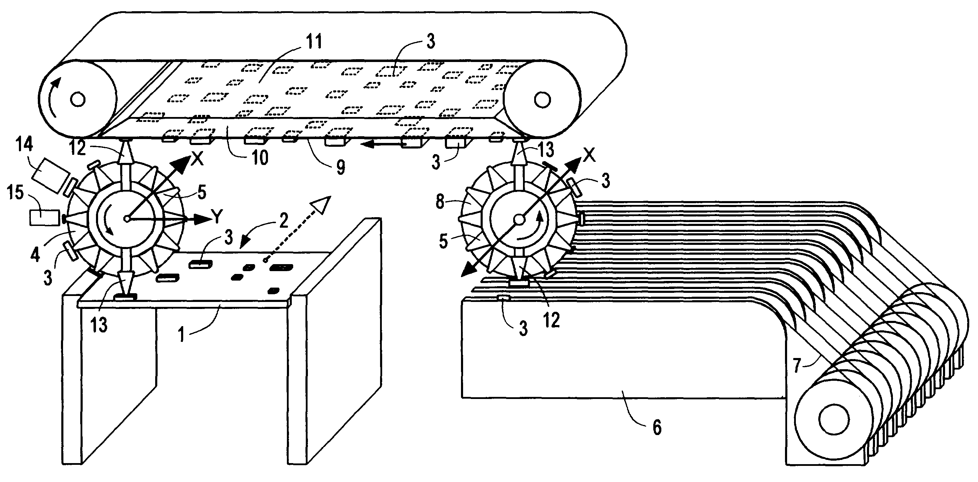

Im folgenden wird die Erfindung anhand eines in der Zeichnung dargestellten Ausführungsbeispieles näher erläutert. Die dargestellte Figur zeigt schematisiert in perspektivischer Ansicht Funktionsmodule einer Vorrichtung zum Bestücken von Leiterplatten mit elektrischen Bauelementen.

Ein als Leiterplatte ausgebildeter Bauelementeträger 1 ist in einem Bestückbereich 2 der Vorrichtung waagerecht liegend derart fixiert, daß Bauelemente 3 auf seiner Oberseite aufgesetzt werden können. Ein Bestückkopf 4 ist oberhalb der Leiterplatte angeordnet und über den gesamten Bestückbereich 2 in x-y-Richtung waagerecht verfahrbar, wie dies durch die entsprechenden Pfeile angedeutet ist. Ein weiterer in der x-Richtung an die Leiterplatte angesetzter Pfeil zeigt die Zu- und Abführrichtung der Leiterplatte.

Der revolverartige Bestückkopf 4 weist sternförmig angeordnete Sauggreifer 5 in Form von Saugpipetten auf, an denen die aufzusetzenden Bauelemente 3 mittels einer Vakuumöffnung gehalten sind. Der Bestückkopf weist eine Abholstation 12 und eine Aufsetzstation 13 für die Bauelemente auf und ist außerdem mit einer optischen Meßstation 14 zur Lageermittlung der Bauelemente 3 versehen. Eine weitere Drehstation 15 dient dazu, die Drehlage der Bauelemente 3 zu verändern und zu korrigieren.

Seitlich des Bestückbereiches sind in der x-Richtung aneinandergereihte Zuführmodule 6 für die Bauelemente 3 angeordnet. Diese sind in auf Spulen gewickelten Gurten 7 gespeichert, die in die Zuführmodule 6 hineingeführt sind. Entnahmeplätze für die Bauelemente 3 in den Zuführmodulen 6 sind in der x-Richtung aneinandergereiht und liegen etwa in gleicher Höhe wie die Bestückebene des Bestückbereiches 2.

Die Bauelemente 3 werden aus den Entnahmeplätzen der Zuführmodule 6 mittels einer Übergabeeinrichtung 8 entnommen, die ähnlich wie der Bestückkopf 4 mit revolverartig angeordneten Sauggreifern 5 für die Bauelemente 3 versehen ist. Dieser hat lediglich die Abholstation 12 und Aufsetzstation 13 für die Bauelemente 3, jedoch keine Vermessungs- oder Verdrehstation. Die Entnahmestellen der Zuführmodule 6 sind auf der dem Bestückbereich 2 zugewandten Seite der Zuführmodule angeordnet. Die Übergabeeinrichtung 8 ist entlang den Entnahmestellen in einer einfachen nicht dargestellten Linearführung in der x-Richtung verfahrbar.

Oberhalb des Bestückkopfes 4 und der Übergabeeinrichtung 8 streckt sich parallel zum Bestückbereich 2 zwischen diesem und der Übergabeeinrichtung 8 ein als Saugband 9 umlaufendes Fixierband, das den gesamten Bestückbereich überdeckt. Die Unterseite des Saugbandes 9 ist unmittelbar über den Oberseiten des Bestückkopfes 4 bzw. der Übergabeeinrichtung 8 angeordnet. Auf der Innenseite des unteren Saugbandabschnittes ist eine zu diesem hin offene Vakuumkammer 10 angeordnet. Das Saugband 9 besteht aus porösem Material, durch dessen eng benachbarte Öffnungen der in der Vakuumkammer 10 erzeugte Unterdruck auf der Außenseite des Saugbandes 9 wirksam wird.

Die aus den Zuführmodulen 6 entnommenen Bauelemente 3 werden durch die Drehbewegung der Übergabeeinrichtung 8 zur gegenüberliegenden Seite des Revolverkopfes transportiert und durch die Verfahrbewegung in der x-Richtung in einer definierten Reihenfolge an definierten Stellen an die Unterseite des Saugbandes 9 angesetzt. Der dort wirksame Unterdruck ist so groß, daß die angesetzten Bauelemente 3 nicht herabfallen können.

Von diesen Aufsetzstellen werden die Bauelemente durch die Bandbewegung bis über die Leiterplatte 1 transportiert und zur Abnahme durch den Bestückkopf 4 bereitgehalten. Dieser Bereich des Saugbandes 9 bildet somit einen Abholbereich 11, der dem Bestückkopf 4 zugänglich ist. Die dort bereitgehaltenen Bauelemente 3 werden von den Sauggreifern 5 des Bestückkopfes 4 angesaugt und abgenommen. Dabei ist der Saugquerschnitt und der Sauggreifer dem Gewicht und der Größe der Bauelemente angepaßt, so daß die Saugkraft der Sauggreifer 5 mit Sicherheit höher ist als die Differenz der Saugkraft des Saugbandes 9 minus dem Eigengewicht der Bauelemente 3.

Der Bestückkopf 4 transportiert die Bauelemente 3 durch seine Drehbewegung zur unten gelegenen Bestückebene und verfährt währenddessen zu den zugehörigen Bestückplätzen auf der Leiterplatte 1. Der Bestückkopf und die Übergabeeinrichtung benötigen für das Aufnehmen und Absetzen der Bauelemente 2 je eine Abhol- und eine Aufsetzstation, wechselweise auf ihrer Ober- und ihrer Unterseite. An diesen Stationen sind die Sauggreifer 5 in einer radialen Hubbewegung nach außen ausfahrbar, um die abzuholenden Bauelemente 3 abheben bzw. aufsetzen zu können.

Die Bestückvorrichtung ist mit einer nicht dargestellten Computersteuerung für die Drehantriebe des Saugbandes 9, des Bestuckkopfes 4 und der Übergabeeinrichtung 8 versehen. Die Computersteuerung regelt ferner die Verfahrbewegungen des Bestückkopfes 4 und der Übergabeeinrichtung 8. Dadurch ist es möglich, die Bauelemente auf dem Saugband 9 derart zu plazieren, daß der Bestückkopf 4 jeweils gleichzeitig ein Bauelement vom Saugband 9 abnehmen und ein anderes Bauelement 3 auf die Leiterplatte 1 aufsetzen kann.

Dies wird dadurch möglich, daß sich das abzuholende Bauelement 3 auf dem Saugplatz an einer Stelle befindet, die der Aufsetzposition eines anderen Bauelementes entspricht, das um eine halbe Umdrehung des Bestückkopfes 4 zuvor abgenommen worden ist. Um jeweils gleichzeitig ein Bauelement 3 abholen und aufsetzen zu können, ist der Bestückkopf mit einer geradzahligen Anzahl von Sauggreifern 5 versehen. Der Bestückkopf ist hier mit 12 Sauggreifern 5 ausgestattet und benötigt daher für eine halbe Umdrehung 6 Drehtakte. Das bedeutet, daß die Abholposition eines Bauelementes 3 auf dem Saugband 9 um 6 Takte vor seiner Aufsetzposition auf der Leiterplatte 1 liegen muß.

Auf diese Weise ist es möglich, die Bauelemente 3 kontinuierlich vom Saugband 9 abzunehmen und auf die Leiterplatte 1 aufzusetzen, wobei der Bestückkopf 4 lediglich die kurzen Wege von Aufsetzposition zu Aufsetzposition zurücklegen muß, wodurch die Bestückleistung drastisch erhöht werden kann. Ein weiterer Vorteil besteht darin, daß der Verfahrbereich des Bestückkopfes auf den Bestückbereich begrenzt werden kann, so daß die erforderlichen Führungseinrichtungen, z.B. in Form von Kreuzführungen kompakter und leichter ausgeführt werden können. Dadurch können die bewegten Massen verringert werden, um die Bestückleistung weiter zu erhöhen.

## Patentansprüche

1. Vorrichtung zum Bestücken von flachen Bauelementeträgern (1) mit elektrischen Bauelementen (3), insbesondere SMT-Bauelementen mittels eines revolverartigen drehbaren Bestückkopfes (4) mit mehreren zirkulär angeordneten, insbesondere pipettenartigen Greifern (z.B. 5) für die Bauelemente (3),
wobei zumindest der Bauelementeträger (1) in einem Bestückbereich (2) der Vorrichtung fixierbar ist,
wobei der Bestückkopf (4) über dem Bestückbereich (2) verfahrbar ist,
wobei die Bauelemente (3) in zumindest einem dem Bestückkopf (4) zugänglichen Abholbereich (11) von den Greifern aufnehmbar und zu ihren Bestückpositionen im Bestückbereich transportierbar sind
und wobei der Bestückkopf (4) eine Aufsetzstation (12) aufweist, an der die Bauelemente (3) auf den Bauelementetrager aufsetzbar sind,
**dadurch gekennzeichnet,**
daß der Abholbereich (11) auf der dem Bestückbereich (2) gegenüberliegenden Seite des Bestückkopfes (4) angeordnet ist,
daß der Bestückkopf (4) zusätzlich zur Aufsetzstation (12) auf der dieser diametral gegenüberliegenden Seite eine Abholstation (13) aufweist, an der der jeweilige Greifer (z.B. 5) das bereitgehaltene Bauelement (3) aufnehmen kann und
daß die im Abholbereich (11) bereitgehaltenen Bauelemente (3) mittels zumindest einer Fixiereinrichtung (z.B. 9)in ihrer Abholposition gehalten werden können.

2. Vorrichtung nach Anspruch 1,
**dadurch gekennzeichnet,**
daß der Bauelementeträger (1) im Bestückbereich (2) waagerecht liegend angeordnet werden kann,
daß der Bestückkopf (4) oberhalb des Bestückbereiches (2) verfahrbar ist,
daß der Abholbereich (11) oberhalb des Bestückkopfes (4) angeordnet ist und
daß die Bauelemente (3) an der Fixiereinrichtung (z.B. 9) hängend gehalten werden können

3. Vorrichtung nach Anspruch 2,
**dadurch gekennzeichnet,**
daß die Fixiereinrichtung (z.B. 9) bewegbar ausgebildet ist und
daß die Bauelemente mittels der Fixiereinrichtung (z.B. 9) in verschiedene Abholpositionen verfahrbar sind.

4. Vorrichtung nach Anspruch 3,
**dadurch gekennzeichnet,**
daß die Bauelemente (3) durch die Fixiereinrichtung (z.B. 9) an Stellen oberhalb des Bestückbereiches bewegbar sind, die mit Aufsetzpositionen von Bauelementen (3) auf den Bauelementeträger (1) übereinstimmen.

5. Vorrichtung nach einem der vorhergehenden Ansprüche,
**dadurch gekennzeichnet,**
daß der Bestückkopf (4) mit einer geradzahligen Anzahl von Greifern (z.B. 5) versehen ist und einen entsprechend getakteten Drehantrieb aufweist und
daß das jeweilige Bauelement (3) an einer Stelle aufnehmbar ist, die der Aufsetzposition eines um eine halbe Umdrehung zuvor abgeholten Bauelementes (3) entspricht.

6. Vorrichtung nach einem der vorhergehenden Ansprüche,
**dadurch gekennzeichnet,**
daß die Fixiereinrichtung als umlaufenden Fixierband (z.B. 9) ausgebildet ist, daß mit eng verteilten Fixiermitteln für die hängende Fixierung der Bauelemente (3) versehen ist.

7. Vorrichtung nach Anspruch 6,
**dadurch gekennzeichnet,**
daß sich das Fixierband (z.B. 9) parallel zum Bestückbereich (2) erstreckt und diesen überdeckt,
daß das Fixierband (z.B. 9) bis über einen Zuführbereich für die Bauelemente (3) geführt ist und
daß die Bauelemente (3) mittels zumindest einer quer zur Vorschubrichtung des Fixierbandes (z.B. 9) verfahrbaren Übergabeeinrichtung (8) aus Zuführmodulen (6) entnehmbar und an das Fixierband (9) ansetzbar sind.

8. Vorrichtung nach Anspruch 7,
**dadurch gekennzeichnet,**
daß die Übergabeeinrichtung (8) als dem Bestückkopf (4) ähnlicher Revolverkopf ausgebildet ist,
daß die Abholstellen der Zuführmodule (6) in einer sich quer zum Fixierband erstreckenden Reihe angeordnet sind und
daß die Bauelemente (3) aus den nach oben offenen Abholstellen von der Übergabeeinrichtung (8) aufnehmbar und auf das Fixierband (z.B. 9) aufsetzbar sind.

9. Vorrichtung nach einem der Ansprüche 6 bis 8,
**dadurch gekennzeichnet,**
daß das Fixierband als Saugband (9) ausgebildet ist und
daß die Fixiermittel als Saugöffnungen ausgebildete sind, die an eine Unterdruckquelle angeschlossen sind.

10. Vorrichtung nach Anspruch 9,
**dadurch gekennzeichnet,**
daß das Saugband (9) aus porösem Material besteht und in seinem dem Bestückkopf (4) zugewandten unteren Abschnitt entlang einer Saugkammer (8) geführt ist, die auf der den Bauelementen abgewandten Seite des Saugbandes (9) angeordnet ist.
